# FASCICULE DE BREVET EUROPEEN

(11) **EP 2 599 109 B1**
(45) Date de publication et mention de la délivrance du brevet: **04.11.2015**
(21) Numéro de dépôt: 11755386.7
(22) Date de dépôt: 29.07.2011
(51) Int. Cl.: B82Y 30/00, C08G 81/02, C09D 187/00, H01L 29/423, H01L 29/788

(54) **FILMS MINCES NANOORGANISÉS À BASE DE COPOLYMÈRES À BLOCS POLYSACCHARIDIQUES POUR DES APPLICATIONS EN NANOTECHNOLOGIE**
IN NANODOMÄNEN ORGANISIERTE DÜNNSCHICHTEN AUF DER BASIS VON COPOLYMEREN MIT POLYSACCHARDBLÖCKEN FÜR ANWENDUNGEN IN DER NANOTECHNOLOGIE
THIN FILMS ORGANISED IN NANODOMAINS ON THE BASIS OF COPOLYMERS HAVING POLYSACCHARIDE BLOCKS FOR APPLICATIONS IN NANOTECHNOLOGY

(30) Priorité: 30.07.2010 FR 1056336
(43) Date de publication de la demande: 05.06.2013
(73) Titulaire: Centre National de la Recherche Scientifique (CNRS), 75016 Paris (FR)
(72) Inventeur: AISSOU, Karim, F-38240 Meylan (FR); HALILA, Sami, F-38140 Beaucroissant (FR); FORT, Sébastien, F-38410 Uriage (FR); BORSALI, Redouane, F-38610 Venon (FR); BARON, Thierry, F-38120 Saint Egreve (FR)
(74) Mandataire: Blot, Philippe Robert Emile
(86) Numéro de dépôt international: PCT/FR2011/051843
(87) Numéro de publication internationale: WO 2012/013911

(56) Documents cités:
- WO-A1-2009/153447
- MORGAN TIZZOTTI, AURELIA CHARLOT, ETIENNE FLEURY, MARTINA STENZEL, JULIEN BERNARD: "Modification of polysaccharides through controlled/living polymerization grafting- Towards the generation of high performance hybrids", MACROMOLECULAR RAPID COMMUNICATIONS, vol. 31, 8 juillet 2010 (2010-07-08), pages 1751-1772, XP002620162, DOI: 10.1002/marc.201000072
- HERNANDEZ-GUERRERO ET AL: "Polystyrene comb polymers built on cellulose or poly(styrene-co-2-hydroxyethylmethacrylate ) backbones as substrates for the preparation of structured honeycomb films", EUROPEAN POLYMER JOURNAL, PERGAMON PRESS LTD. OXFORD, GB, vol. 41, no. 10, 1 octobre 2005 (2005-10-01), pages 2264-2277, XP005009411, ISSN: 0014-3057
- BO KYUNG YOON ET AL: "Direct Patterning of Self Assembled Nano-Structures of Block Copolymers via Electron Beam Lithography", MACROMOLECULAR RESEARCH, POLYMER SOCIETY OF KOREA, SEOUL, KR, vol. 13, no. 5, 1 octobre 2005 (2005-10-01), pages 435-440, XP007906908, ISSN: 1598-5032

## Description

La présente invention concerne un matériau comprenant un substrat dont l'une des surfaces est recouverte d'une couche à base d'un copolymère à blocs et ses applications pour :
- la fabrication d'un matériau utile pour l'électronique, notamment la fabrication de mémoires flashs, de transistors verticaux, de mémoire à accès non séquentiel (RAM), de transistors selon les technologies FET et CMOS,
- pour réaliser des diodes électroluminescentes organiques (OLED) ou des composants de cellules photovoltaïques organiques (OPV), ou
- pour la conception de dispositifs de détection (nanobiocapteurs, biopuces) utilisables en chimie, an agroalimentaire ou dans le domaine de la santé.

L'auto-assemblage de copolymères à blocs permet de contrôler l'organisation de nanodomaines, et de préparer ainsi des films avec une densité d'intégration de divers objets nanométriques (trous, plots, lamelles, piliers, couches...) appropriée à des usages spécifiques qui requièrent des matériaux avec une densité élevée de zones actives. Cette approche est particulièrement intéressante dans les secteurs industriels dont les enjeux économiques demandent de dépasser les limites des procédés conventionnels pour développer des objets de plus en plus miniaturisés. Par exemple, l'essor de la microélectronique est limité par les techniques de lithographie optique, ou de gravure. C'est aussi le cas de l'éclairage LED devant dépasser les technologies LCD, plasma. De même, les technologies «micro-array », et micro-fluidique ne sont pas appropriées au développement des systèmes performants de multidétection simultanée et/ou de détection directe (SPR, SERS, nanosondes fluorescentes,..) de molécules voire à l'échelle de molécules isolées.

Le brevet US 7,045,851 décrit l'utilisation d'un copolymère dibloc synthétique, constitué de polystyrène (PS) et de poly(méth)acrylate de méthyle (PMMA), déposé sur une couche d'oxyde de silicium pour former une grille flottante discrète d'un transistor à effet de champ. Les nanodomaines organisés à base de blocs PMMA ont une période de réseau de l'ordre de 40 nm.

La demande de brevet EP 2 088 618 décrit l'utilisation d'un copolymère dibloc polystyrène (PS)-poly(méth)acrylate de méthyle (PMMA) pour la préparation d'un masque lithographique. Le procédé permet la préparation de grilles flottantes pour la microélectronique dont les dimensions de zone active sont 0,25 x 0,32 Pm².

Zhang et al. (Advanced Material 2007 19, 1571-1576) décrit l'utilisation d'un copolymère dibloc polystyrène (PS)-polyéthylèneoxyde (PEO) pour la préparation d'un masque lithographique utile pour la microélectronique. Les nanodomaines organisés à base de blocs PEO ont une période de réseau de l'ordre de 22 nm. La feuille de route de l'ITRS (« International Technology Roadmap for Semiconductors, 2005 Edition») indique qu'un réseau de nanodomaines d'une période inférieure à 22 nm est le « noeud technologique » à dépasser d'ici 2020 pour répondre aux enjeux économiques du secteur de la microélectronique.

Le développement des matériaux comprenant des réseaux de nanodomaines ayant des périodes plus faibles pour permettre une meilleure miniaturisation des dispositifs utilisés en micro-électronique, pour réaliser des diodes électroluminescentes organiques ou des cellules photovoltaïques organiques ou pour la conception de dispositifs de détection est donc particulièrement important. Un objectif de la présente invention est de fournir des matériaux (M) comprenant un réseau de nanodomaines ayant une période plus faible que celle des matériaux existants.

A cet effet, selon un premier aspect, l'invention fournit un matériau (M) comprenant un substrat dont l'une des surfaces est recouverte d'une couche d'un réseau organisé à base d'un copolymère à blocs (ou éventuellement un mélange de copolymères à blocs) comprenant :
- un bloc (A) constitué d'un polymère hydrophobe, et
- un bloc (B) constitué d'un polysaccharide.

Le matériau (M) comprend un substrat dont l'une des surfaces est recouverte partiellement ou totalement d'une couche à base d'un copolymère à blocs sous forme de réseau organisé comprenant des nanodomaines à base de blocs (B) et/ou des nanodomaines à base de blocs (A). Au sens de la présente demande, un "réseau" est un ensemble de points en trois dimensions qui présente la propriété suivante : lorsque l'on se translate dans l'espace selon certains vecteurs, on retrouve exactement le même environnement. Il y a une périodicité spatiale. Le réseau organisé selon l'invention est caractérisé par une période de réseau qui correspond à la distance entre deux nanodomaines de blocs de même nature des copolymères à blocs auto-assemblés.

Cette organisation en nanodomaines est due à l'auto-assemblage de blocs présentant des propriétés antagonistes. Par "auto-assemblage" des blocs, on entend que les blocs de même nature du copolymère à blocs se sont mis en ordre spontanément sur le support pour former le réseau organisé, grâce aux propriétés antagonistes des blocs de natures différentes (par exemple hydrophile/hydrophobe ; chargé/neutre ; polaire/apolaire ; flexible/rigide...).

Les inventeurs ont en effet découvert dans le cadre de la présente invention qu'en remplaçant un des blocs d'un copolymère à blocs de l'art antérieur et apte à s'autoassembler pour former un réseau organisé, par un bloc poly- ou oligosaccharidique et en conservant la masse moléculaire totale du copolymère à blocs, la période de réseau du réseau organisé obtenu est plus faible.

La couche du matériau (M) selon l'invention comprenant le film ordonné a avantageusement une faible période de réseau, généralement inférieure à 22 nm, typiquement inférieure ou égale à 20 nm, notamment inférieure à 15 nm, pouvant même atteindre 11 nm. Cette période de réseau est plus faible que dans les films formés à partir d'autres copolymères à blocs de l'art antérieur, ce qui permet des applications du matériau (M) pour la fabrication d'objets très miniaturisées pour les besoins des nanotechnologies, et de la microélectronique, en particulier.

Généralement, le copolymère à blocs a une masse moléculaire moyenne en poids inférieure ou égale à 40 000 g/mol. Des masses moléculaires moyennes en poids inférieures à 40 000 g/mol favorisent en effet l'obtention d'une faible période de réseau.

Les blocs (A) et (B) du copolymère à blocs sont liés par liaison covalente. Par "copolymère à blocs", on entend que le copolymère est constitué de blocs en séquence linéaire. En particulier, les copolymères peignes qui comportent des chaînes ramifiées ne sont pas des copolymères à blocs.

Plus il y a de blocs dans le copolymère à blocs, plus la structure de la couche de réseau organisé est complexe. Par conséquent, le copolymère à blocs est typiquement dibloc ou tribloc, de préférence dibloc.

Le bloc (A) est un polymère hydrophobe, notamment choisi parmi un polystyrène, un polyalkylstyrène, un poly((méth)acrylate d'alkyle), un polyalkylène, un polyacétylène, un poly (oxyde ou sulfure de polyphénylène), un polydialkylsiloxane, un polyvinylpyridine, un polyalkylèneoxyde, un poly(alkyl thiophène) tel qu'un poly(3-hexylthiophène), un polypyrrole, un poly-N-isopropylacrylamide, un polycaprolactone, un polyimide ou un polyester de préférence biodégradable, tel qu'un polyhydroxyalkanoate ou un polylactide.

Par « (méth)acrylate » on entend un méthacrylate ou un acrylate.

Un alkyle peut être linéaire ou ramifié et comprend généralement de 1 à 6 atomes de carbone. Un alkylène comprend généralement de 1 à 6 atomes de carbone.

Le polyéthylène, le polyisoprène, le polybutadiène et le polyisobutylène sont les polyalkylènes préférés. Le polybutylstyrène est le polylalkylstyrène préféré. Le polyméthylméthacrylate, le polybutylméthacrylate, le polybutylacrylate et le polyhexylacrylate sont les poly((méth)acrylate d'alkyle) préférés. Le polydiméthylsiloxane est le polydialkysiloxane préféré. Le polyéthylène oxyde est le polyalkyleneoxyde préféré.

De préférence, le bloc (A) est constitué de polystyrène, de poly(alkyl (méth)acrylate ou de poly (3-hexylthiophène), et en particulier de polystyrène ou de poly(alkyl (méth)acrylate.

Le bloc (A) est de préférence constitué d'un polystyrène de degré de polymérisation de 10 à 30, notamment de 15 à 20, en particulier de 18.

Le polysaccharide du bloc (B) a de préférence un degré de polymérisation (DP) de 2 à 40, notamment de 2 à 20, de préférence de 5 à 9, en particulier de l'ordre de 7. L'auto-assemblage des copolymères à blocs est en effet favorisée lorsque le bloc (B) polysaccharide de 2 à 40 unités, notamment de 2 à 20 unités. Ainsi, le polysaccharide du bloc (B) du copolymère à blocs peut être un oligosaccharide (typiquement, un oligosaccharide a un degré de polymérisation inférieur ou égal à 10).

Les unités du bloc (B) peuvent être composées du même saccharide ou de saccharides différents. Ces saccharides peuvent notamment être choisis parmi le maltose, la cellulose et ses dérivés tels que la carboxyméthylcellulose, l'acétate de cellulose, l'hydroxyéthylcellulose, l'amidon, la chitine, le chitosane, le xyloglucane, la pectine, les carraghénanes, les dextranes, les glucanes, notamment beta 1,3 et beta 1,6, et O- glycanes, N-glycanes ou C-glycanes. De préférence, le bloc (B) est du maltoheptaose ou du maltooctadécaose, en particulier du maltoheptaose.

Les polysaccharides sont avantageusement issus d'espèces végétales et permettent de valoriser la biomasse.

Les polysaccharides peuvent être synthétisés par voie chimique ou par voie recombinante (par ingénierie des glycosyltranférases ou des glycosylhydrolases). Ils peuvent provenir avantageusement de biomasses d'origine diverse: plantes, algues, bactéries, champignons, co-produits industriels, déchets agricoles, etc... La biomasse peut ainsi être valorisée par l'utilisation de ses composants à l'échelle nanométrique, en particulier pour la fabrication de matériaux à haute-valeur ajoutée et utiles en nanotechnologie.

Un copolymère dibloc où le bloc (A) est du polystyrène et où le bloc (B) est du maltoheptaose est particulièrement préféré selon l'invention.

Quelle que soit leur nature, les copolymères diblocs employés selon l'invention peuvent être synthétisés selon toute méthode connue en soi, décrite, par exemple, par la méthode décrite dans "Block copolymers. I. Advances in polymer science, vol.189; Ed. Volker Abetz (Institut für Polymerforschung, Geesthacht, Germany)". Springer: Berlin, Heidelberg, New York. 2005.

En particulier, les blocs (A) et (B) peuvent être synthétisés séparément, puis on introduit chimiquement des fonctions terminales réactives sur chacun des blocs (à moins que ces fonctions soient déjà présentes à la fin de la synthèse du bloc). Les fonctions terminales réactives sont choisies de manière à ce qu'elles soient orthogonales (c'est-à-dire que la fonction d'un bloc ne puisse pas réagir avec la fonction d'un bloc de même nature mais soit capable de réagir exclusivement avec les fonctions de blocs différents). On fait ensuite réagir les blocs entre eux. Cette voie de synthèse (voie « click ») est souvent préférée à d'autres techniques car elle évite une étape de protection des groupes OH contenus sur le polysaccharide.

De préférence, la fraction volumique du bloc (A) dans le copolymère à blocs est comprise entre 0,1 et 0, 4, notamment lorsque le degré de polymérisation du bloc (B) polysaccharidique est entre 2 et 20.

Dans un mode de réalisation, le bloc (B) est lié par liaison hydrogène à au moins une molécule comprenant une fonction amine, amide, hydroxyle et/ou une fonction acide carboxylique. Ces fonctions sont en effet particulièrement adaptées pour se lier par liaison hydrogène aux fonctions hydroxyle du polysaccharide. La molécule a généralement un faible poids moléculaire, typiquement inférieur à 500 g/mol. La molécule n'est pas un bloc saccharidique d'un autre copolymère à bloc. Cette molécule peut par exemple être la 4',4-bipyridine, la 2',2-bipyridine, la 2-(2,4-difluoro phenyl)pyridine ou l'acide 9-anthracène carboxylique, de préférence la 4',4-bipyridine.

Des liaisons hydrogène peuvent être formées entre la molécule et le bloc polysaccharide (B) du copolymère par dissolution de la molécule et du copolymère à blocs dans un solvant aprotique, par exemple du tétrahydrofurane, dioxane, toluène, chloroforme, acétone, éther ou dimethylformamide. Les solvants protiques de type eau ou alcool sont à proscrire, car la formation de liaisons hydrogène entre la molécule et l'oligo-polysaccharide serait en compétition avec la formation de liaisons hydrogène entre la molécule et le solvant protique, d'une part, et entre le polysaccharide et le solvant protique, d'autre part.

L'auto-assemblage des copolymères à blocs est favorisé par la présence de cette molécule, bien qu'elle ne soit pas indispensable. Par exemple, il a été vérifié en diffraction X (spectre SAXS) que le système amylose-bloc-polystyrène, et en particulier polystyrène-maltooctadecaose pouvait s'auto-organiser sans l'aide de 4',4-bypiridine.

La présence de ces molécules liées aux blocs (B) saccharidiques par liaisons hydrogène a pour effet de faire varier les paramètres régissant le diagramme de phase, à savoir : la fraction volumique du bloc rigide (B), ou bien le rapport G = ω/χ. [ω, connu sous le nom d'interactions de Maier-Saupe, régit les interactions entre les blocs rigides anisotropes ; χ, connu sous le nom de paramètre de Flory-Huggins, exprime la répulsion entre les différents blocs]. Autrement dit, la constitution de chaînes supramoleculaires par fixation de ces molécules a pour effet de contrôler la séparation de phase en offrant la possibilité d'obtenir une phase différente pour une température donnée de recuit lors de l'étape β.

La molécule peut être photoluminescente, c'est-à-dire qu'elle est capable d'absorber des photons puis de réémettre l'énergie absorbée sous la forme d'une lumière de plus grande longueur d'onde.

Généralement, la proportion molaire entre la molécule et le bloc (B) varie entre 0,1 et 1,0.

Le substrat du matériau (M) est typiquement un support solide de faible rugosité et de dimensions et/ou de formes variables.

Dans un premier mode de réalisation, le substrat comprend du silicium. Le matériau (M) selon ce mode de réalisation sera désigné (M_{Si}) ci-après pour des raisons de concision. Le substrat peut consister en du silicium, par exemple une plaque de silicium ou être du silicium recouvert par un matériau isolant ou diélectrique, par exemple des microbilles de SiO₂. La couche de matériau isolant ou diélectrique recouvrant le silicium a notamment une épaisseur de 2 à 5 nm. Ce premier mode de réalisation convient particulièrement aux applications en électronique.

Un matériau particulièrement préféré comprend un substrat en silicium dont l'une des surfaces est recouverte d'une couche d'un réseau organisé à base d'un copolymère à blocs comprenant :
- un bloc (A) constitué d'un polymère polystyrène de degré de polymérisation de 18, et
- un bloc (B) constitué d'un maltoheptaose de degré de polymérisation de 7, ledit maltoheptaose étant lié par liaison hydrogène à la 4',4-bipyridine.

Dans un deuxième mode de réalisation, le substrat est un polymère (par exemple du poly(3,4-éthylènedioxythiophène) (PEDT)), du verre, du métal (par exemple de l'or, du titane, du platine) ou un oxyde métallique (par exemple du dioxyde de titane). Le matériau (M) obtenu selon ce mode de réalisation sera désigné (M_{PVM}) ci-après. Ce deuxième mode de réalisation convient particulièrement aux applications OLED, OPV et nanobiocapteurs.

Selon un second aspect, l'invention concerne le procédé de préparation d'un matériau (M) tel que défini ci-dessus, comprenant une étape de séparation de phase, notamment par traitement thermique (étape de recuit).

Le procédé peut comprendre notamment les étapes consistant en :
α) le dépôt d'une solution comprenant ledit copolymère à blocs sur un substrat pour obtenir un matériau (m),
β) le chauffage du matériau (m) obtenu à la fin de l'étape α) à une température de 140 à 220 °C.

La préparation du matériau (M) s'inscrit dans un développement industriel durable en valorisant la biomasse à l'échelle nanométrique (avec le remplacement de polymères synthétiques issus du pétrole par des polysaccharides) et en utilisant préférentiellement des procédés de chimie verte.

Le solvant de la solution mise en oeuvre dans l'étape α est typiquement un solvant aprotique, par exemple du tétrahydrofurane.

L'étape α est typiquement réalisée par dépôt de la solution à la tournette (« spin coating » en anglais), par sérigraphie ou par jet d'encre. Le dépôt par jet d'encre est particulièrement adapté pour réduire la quantité de solution utilisée et ainsi le coût du procédé et permet également de déposer la solution sur des zones localisées à la surface du substrat.

Lors de l'étape β, qui correspond à une étape de recuit, les blocs du copolymère s'auto-assemblent, ce par quoi on obtient un matériau (M) comprenant un substrat dont l'une des surfaces est recouverte d'une couche à base d'un copolymère à blocs sous forme de film ordonné comprenant des nanodomaines constitués des blocs (B), et généralement des nanodomaines constitués des blocs (A) et des nanodomaines constitués des blocs (B). L'homme du métier sait comment adapter les conditions de cette étape en prenant en compte les propriétés chimiques antagonistes des blocs (A) et (B) [(hydrophile/hydrophobe ; chargé/neutre ; polaire/apolaire ; flexible/rigide...) ; (le bloc (B) polysaccharide étant hydrophile, polaire et rigide et le bloc (A) étant hydrophobe)] et plus particulièrement la rigidité du bloc (B) polysaccharidique ainsi que sa faible solubilité en solvant organique.

La température lors de l'étape β est de 140 à 220°C, de préférence de 150 à 200 °C. Le recuit peut être effectué sous atmosphère contrôlée, par exemple en milieu CO₂ supercritique.

L'auto-assemblage des blocs et donc la géométrie du réseau obtenu dépend de plusieurs facteurs, tels que la longueur des chaînes du copolymère, l'épaisseur de la couche, la température et la durée de recuit.

La caractérisation de la couche peut être effectuée par différentes techniques comme la microscopie en force atomique (AFM), la microscopie électronique en transmission (MET ou TEM en anglais), l'ellipsométrie, la technique de diffusion des rayons X aux petits angles (SAXS, Small Angle X-ray Scattering en anglais), la technique de diffusion des rayons X aux petits angles en incidence rasante (GISAXS, Grazing Incidence Small Angle X ray Scattering en anglais) ou la microscopie électronique à balayage à haute résolution (MEB) .

La couche formée lors de l'étape β) a généralement une épaisseur de l'ordre de la périodicité des nanodomaines formés.

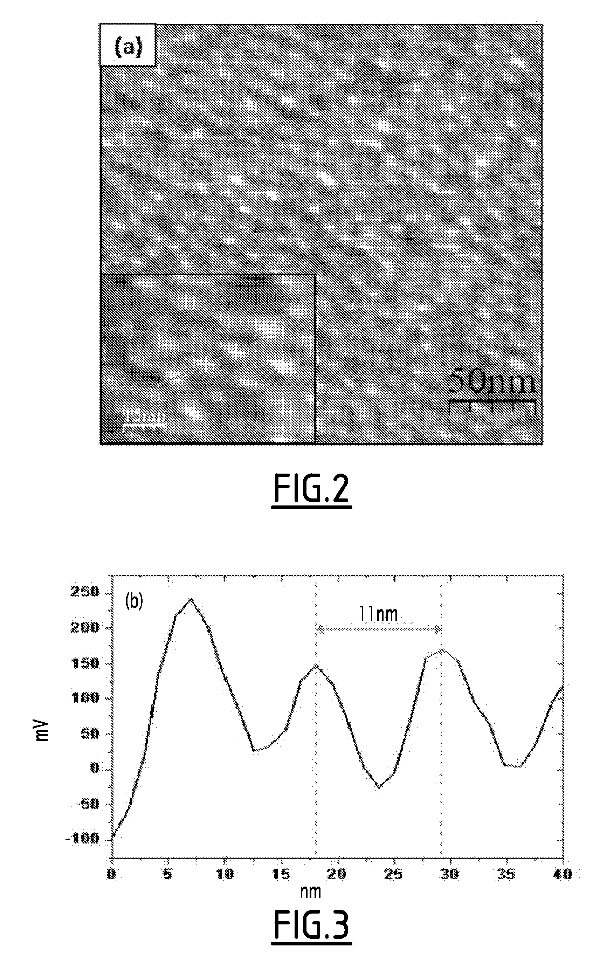

Les nanodomaines comprenant les blocs (B) polysaccharide peuvent notamment être orientés :
- soit de façon parallèle au plan du substrat, le matériau (M) étant alors appelé (M//) (figure 4) : une telle organisation de copolymères à blocs a été décrite dans le brevet FR 2 927467,
- soit de façon perpendiculaire au plan du substrat, le matériau (M) étant alors appelé (M⊥) (figure 2).

La morphologie parallèle ou perpendiculaire de la structure périodique est contrôlable par le traitement thermique, la nature des solvants et par différents facteurs en rapport avec la composition des blocs, et notamment par la fraction volumique bloc (B) / bloc (A).

Par exemple, lorsque le copolymère comporte une quantité équimolaire de molécule liée par liaison hydrogène au bloc (B) polysaccharidique et d'unités saccharidiques dans le bloc (B) polysaccharidique, les nanodomaines forment généralement des lignes parallèles au plan du substrat. Par contre, lorsque le copolymère comporte une quantité équimolaire de molécule liée par liaison hydrogène au bloc (B) polysaccharidique et de groupes hydroxyles dans le bloc (B) polysaccharidique, les nanodomaines forment généralement des lignes perpendiculaires au plan du substrat. Lorsque le copolymère comporte moins de molécules liées par liaison hydrogène au bloc (B) polysaccharidique que d'unités saccharidiques dans le bloc (B) polysaccharidique, les nanodomaines forment généralement des cylindres dont les axes sont perpendiculaires au plan du substrat.

Ainsi, la nature des blocs (A) et (B) du copolymère à blocs, leurs fractions volumiques respectives, la présence ou non de molécules liées par liaison hydrogène au bloc (B) et les conditions des étapes α et β sont choisies de façon à obtenir le système cristallin le plus adapté à l'application envisagée.

Par exemple, une organisation perpendiculaire au substrat (M⊥), notamment une phase hexagonale compacte de cylindres dont l'axe est perpendiculaire au plan de substrat, est préférée pour les applications transistors verticaux, mémoires et nanobiocapteurs, qui nécessitent la réalisation de plots, trous et piliers, tandis qu'une organisation parallèle au substrat (M//), de type phase lamellaire, est souhaitée pour les applications OLED ou OPV qui nécessitent une organisation des nanodomaines parallèlement au substrat.

Des applications du matériau (M) sont décrites ci-dessous, tout d'abord les applications en nanoélectronique et pour la fabrication de nanobiocapteurs, puis les applications comme composant d'une diode électroluminescente organique ou d'une cellule photovoltaïque organique.

Selon un troisième aspect, l'invention concerne l'utilisation d'un matériau tel que défini ci-dessus à titre de précurseur d'un masque lithographique en électronique.

L'invention a notamment pour objet:
- un procédé de préparation d'un matériau (M_{TROU}), comprenant l'étape a) consistant à traiter la couche de copolymère du matériau (M) de manière à éliminer sélectivement l'un des blocs (A) ou (B) et à former des cavités séparées les unes des autres par le reste du copolymère, et,
- le matériau (M_{TROU}) susceptible d'être obtenu par ce procédé.

Ainsi, il est possible :
- soit d'ôter sélectivement les blocs (A) pour former des cavités séparées les unes des autres par les blocs (B) restants, le matériau étant alors désigné (M_{TROU(A)}),
- soit d'ôter sélectivement les blocs (B) polysaccharidiques pour former des cavités séparées les unes des autres par les blocs (A) restants, le matériau étant alors désigné (M_{TROU(B)}).

L'élimination sélective de l'un des blocs peut se faire par gravure réactive plasma (notamment plasma d'oxygène), par traitement chimique ou enzymatique ou par exposition à l'UV profond ( « deep-UV »).

Pour ôter sélectivement les blocs (B) polysaccharidique afin d'obtenir le matériau (M_{TROU(B)}), l'étape a) est réalisée en mettant le matériau (M) en contact d'un acide choisi parmi H₅IO₆, HCl ou TFA (acide trifluoroacétique). Ce traitement se différencie de ceux décrits antérieurement dans les documents US 2004/0256662 et FR 2 927 467. Par ailleurs, ce traitement est facilement mis en oeuvre, contrairement aux procédés de gravure ionique réactive ayant lieu au sein d'un plasma avec des appareillages spécifiques qui requièrent le contrôle de nombreux paramètres (choix des gaz, pression, puissance, température, polarisation).

L'invention concerne également l'utilisation du matériau (M_{TROU}) comme masque lithographique en électronique, notamment pour la préparation d'une mémoire flash, d'un transistor vertical ou d'une mémoire à accès non séquentiel.

Ainsi, le matériau (M_{TROU}) peut être mis en oeuvre dans un procédé de préparation d'une mémoire flash, d'un transistor vertical ou d'une mémoire à accès non séquentiel comprenant les étapes consistant en:
b) déposer un matériau métallique ou semi-conducteur dans les cavités formées lors de l'étape a) sur le matériau (M_{TROU}),
c) traiter le matériau obtenu à l'étape b) par gravure réactive plasma, par traitement chimique ou enzymatique ou UV pour ôter sélectivement le bloc restant de copolymère et former des cavités séparées les unes des autres par le matériau métallique ou semiconducteur,
d) déposer un matériau diélectrique, par exemple du dioxyde de silicium, dans les cavités formées lors de l'étape c).

Lorsque le matériau (M_{TROU(A)}) est mis en oeuvre dans l'étape b), le bloc restant reste de copolymère de l'étape c) consiste en les blocs (B). Lorsque le matériau (M_{TROU(B)}) est mis en oeuvre dans l'étape b), le bloc restant de copolymère de l'étape c) consiste en les blocs (A).

Ce procédé et les matériaux métalliques semi-conducteurs et diélectriques utilisables sont notamment décrits dans les documents US 2004/0256,652 et FR 2 927 467.

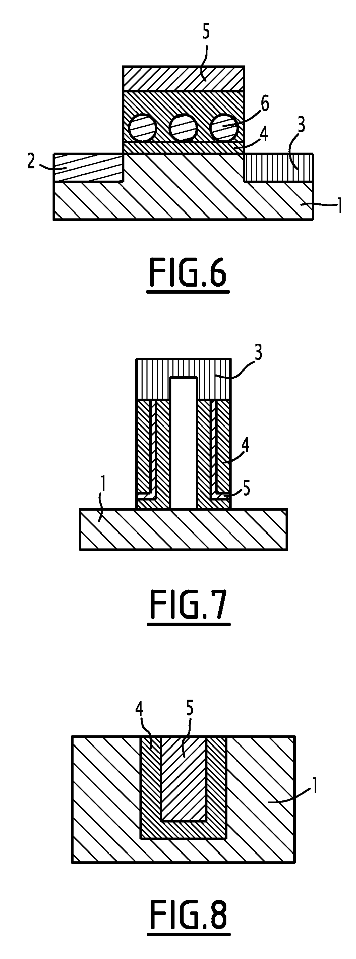

Le type d'organisation des nanodomaines de la couche de film organisé sur le substrat influence les possibilités d'applications potentielles. Ainsi, le matériau (M⊥) est particulièrement adapté pour la préparation d'une grille d'un transistor vertical (figure 7) ou d'une mémoire RAM (figure 8) alors qu'un matériau (M//) est particulièrement adapté pour la fabrication d'une grille flottante d'une mémoire flash (figure 6).

Généralement, pour les applications en électronique susmentionnées, le substrat du matériau (M), et donc du matériau (M_{TROU}) qui en est issu, comprend ou consiste en du silicium, par exemple une plaque de silicium, ou consiste en une plaque de silicium recouverte par un matériau isolant ou diélectrique (par exemple des microbilles de SiO₂), la couche dudit matériau isolant ou diélectrique recouvrant la plaque ayant par exemple une épaisseur de 2 à 5 nm. Le matériau (M_{TROU}) a alors été obtenu à partir du matériau (M_{Si}) tel que défini ci-dessus. Le silicium est en effet le semiconducteur le plus utilisé en électronique.

Les mémoires flash, transistor vertical et RAM obtenus à partir du matériau (M_{TROU}) (et donc du matériau (M)) sont ainsi obtenus par un procédé simple et peu coûteux. Les mémoire flash, transistor vertical et RAM obtenus présentent une densité élevée de motifs organisés de taille nanométrique grâce à la faible période de réseau des nanodomaines du matériau (M) mis en oeuvre dans leur procédé de préparation, et sont donc très miniaturisés.

De plus, l'invention concerne l'utilisation du matériau (M_{TROU}) pour la fabrication de nanobiocapteurs et de nanobiopuces.

En effet, le matériau (M_{TROU}) peut être mis en oeuvre dans un procédé de préparation d'un nanobiocapteur ou d'une nanobiopuce, comprenant l'étape b') consistant à greffer des biomolécules (telles que des peptides ou protéines, des anticorps, des acides désoxyribonucléiques, des oligo- ou polysaccharides...) dans les cavités formées lors de l'étape a) sur le matériau (M_{TROU}).

Le nanobiocapteur et la nanobiopuce formés peuvent être intégrés dans des dispositifs de détection utilisés dans le domaine médical, dans l'agroalimentaire ou en chimie.

Selon un quatrième aspect, l'invention concerne une diode électroluminescente organique (OLED) ou une cellule photovoltaïque organique (OPV) comprenant un matériau (M) dans lequel le bloc (B) est lié par liaison hydrogène à une molécule photoluminescente comprenant une fonction amine, amide, hydroxyle et/ou une fonction acide carboxylique.

Il est ainsi possible de fabriquer des OLED avec une bonne efficacité, à faible coût et sur un substrat qui peut être rigide ou flexible.

Actuellement, les OLED présentant une bonne efficacité sont réalisées à partir de plusieurs couches de matériaux :
- couches de transport des électrons (CTE),
- couche active, et
- couche de transport des trous (CTT),
qui sont déposées séquentiellement par évaporation sous vide sur une anode. Ce mode de dépôt implique un coût de fabrication des OLED plus élevé que celui proposé dans la présente invention. La diminution du coût de fabrication des OLED selon l'invention est liée au fait que le film ordonné peut être déposé soit à la tournette, soit à la l'aide de techniques d'impression telles que la sérigraphie ou le jet d'encre, qui sont des techniques peu coûteuses. De plus, l'utilisation d'un film mince de copolymères à blocs en temps que matériau de base pour réaliser des OLED ne rend plus nécessaire le dépôt sous vide des différentes couches de transport (CTE et CTT) puisque la séparation de phases entre les blocs polysaccharide et les autres blocs du copolymère à blocs engendre la présence d'interfaces entre les nanodomaines qui sont autant d'interfaces de dissociation des excitons. Les nanodomaines formés dans les films ont une taille inférieure à la longueur de diffusion des excitons, typiquement de 10 nm. Cela se traduit par une dissociation très efficace des excitons puisque ces derniers placés n'importe où dans le matériau trouvent une interface de dissociation plus proche que leur longueur de diffusion.

De plus, les molécules photoluminescentes sont liées par liaison hydrogène aux nanodomaines à base de blocs (B) du matériau (M) et ont par conséquent une organisation spatiale très ordonnée sur le matériau (M). Le signal émis par une OLED comprenant un tel matériau (M) est donc intéressant.

L'invention sera encore illustrée au vu des figures et exemples suivants.

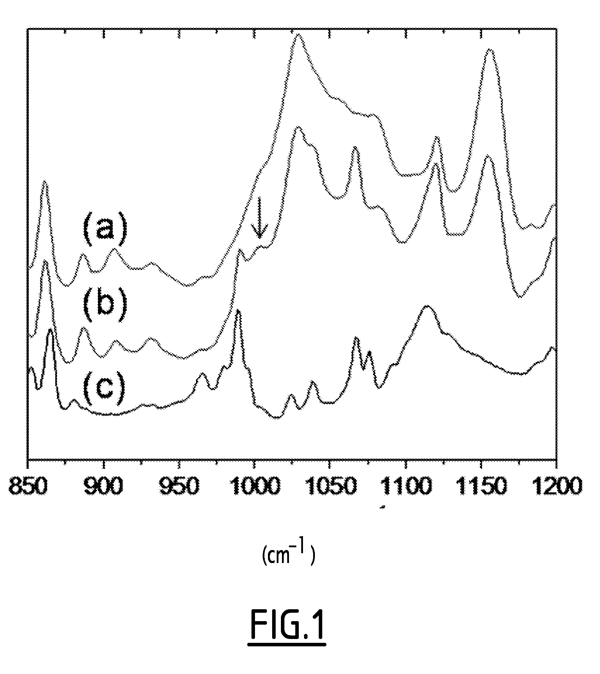

La figure 1 représente trois spectres infrarouge à transformées de Fourier (FTIR) obtenus par un spectromètre FTIR (Spectrum IR I, PERKIN EIMER) en mode KBr des films synthétisés dans l'exemple 1 soit les spectres d'un film de copolymère dibloc polystyrène-maltoheptaose (courbe (a)), d'un copolymère dibloc polystyrène-maltoheptaose lié par liaison hydrogène à la 4,4'-bipyridine (courbe (b)) et de la 4,4'-bipyridine (courbe (c)).
   La flèche sur la courbe b indique le pic à 989 cm⁻¹ (δ= 15 cm⁻¹) caractéristique de la formation de liaisons hydrogène entre la 4,4'-bipyridine et les groupes hydroxyle du maltoheptaose (déplacement d'une partie de la bande caractéristique de la 4,4' bipyridine)
La figure 2 est l'image en microscopie à force atomique obtenue avec un appareil "Picoplus Molecular Imaging" opérant en mode "Taping" d'un film mince de copolymère dibloc polystyrène-maltoheptaose lié par liaison hydrogène à la 4,4' bipyridine obtenu selon l'exemple 1 (film préparé par dépôt à la tournette d'une solution diluée de copolymère (0.5% w/w) sur un substrat d'oxyde de Si (100) suivi d'un recuit sous vide à 170 °C pendant 24h). Les nanodomaines sont sous forme de cylindres dont l'axe est perpendiculaire au plan du substrat. Le matériau correspond au matériau (M_{⊥}) avec une organisation de nanodomaines dans un système cristallin cubique centré. Chaque zone claire correspond à un nanodomaine constitué de blocs oligosaccharide lié à la 4,4'-bipyridine et les zones plus foncées les entourant correspondent aux blocs polystyrène.
La figure 3 représente un profil d'une vue en coupe correspondant à une ligne continue sur l'image en microscopie à force atomique en mode phase de la figure 2. La tension en mV est représentée en fonction de la distance en nm. Chaque pic correspond à un nanodomaine constitué de blocs oligosaccharides liés à la 4,4' bipyridine. La période de réseau est de 11 nm.

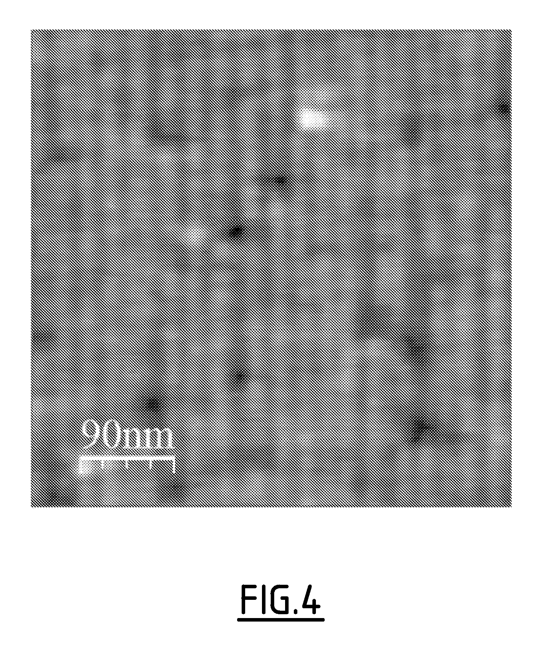

La figure 4 est l'image obtenue en microscope à force atomique obtenue avec un appareil "Picoplus Molecular Imaging" opérant en mode "Taping" d'un film mince de copolymère dibloc polystyrène-maltoheptaose lié par liaison hydrogène à la 4,4' bipyridine (film préparé par dépôt à la tournette d'une solution diluée de copolymère (0.5% w/w) sur un substrat d'oxyde de Si (100) suivi d'un recuit sous vide à 170°C pendant 24h). Les nanodomaines sont parallèles au plan du substrat. Le matériau correspond au matériau (M//). Chaque ligne claire correspond à un nanodomaine constitué de blocs oligosaccharidiques liés à la 4,4'-bipyridine et les lignes plus foncées les entourant correspondent aux blocs polystyrène.

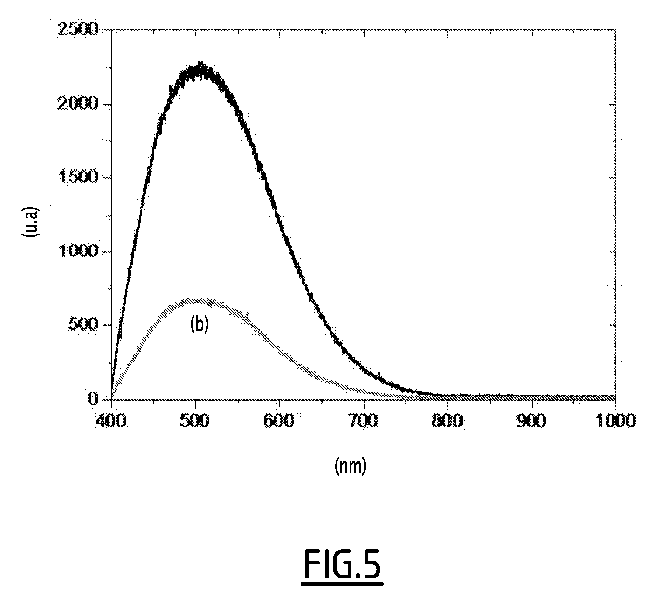

La figure 5 représente le spectre en photoluminescence d'un film de copolymère dibloc polystyrène-maltoheptaose lié par liaison hydrogène à la 4,4'-bipyridine (copolymère de l'exemple 1) obtenu par excitation à 365 nm après recuit à 170°C pendant :
   a) 15 minutes (faible organisation des nanodomaines) et
   b) après 45 heures (nanodomaines de maltoheptaose lié par liaison hydrogène à la 4,4' bipyridine organisés dans un système cristallin cubique centré).
La figure 6 correspond à une vue schématique en coupe d'une mémoire flash. (1) : silicium (substrat utilisé pour la fabrication du matériau (M_{Si})); (2) : Source ; (3) : Drain ; (4) : SiO₂ (matériau diélectrique) ; (5) : Grille (polysilicium) ; (6) : Grille flottante en matériau métallique ou semi-conducteur.
La figure 7 correspond à une vue schématique en coupe d'un transistor vertical : (1) : source en silicium (substrat utilisé pour la fabrication du matériau (M_{Si})) ; (3) : Drain ; (4) : SiO₂ (matériau diélectrique) ; (5) : Grille (polysilicium).
La figure 8 correspond à une vue schématique en coupe d'une mémoire RAM : (1) : silicium (substrat utilisé pour la fabrication du matériau (M_{Si})) ; (4) : SiO₂ (matériau diélectrique) ; (5) : Grille (polysilicium, TaN). La zone occupée par le SiO₂ et la grille correspond aux nanotrous obtenus en gravant le silicium du substrat du matériau (M1).

### EXEMPLE 1 : Préparation d'un copolymère dibloc polystyrène-maltoheptaose.

### a) Synthèse de ω-azido-polystyrène (bloc (A)):

Du ω-azido-polystyrène a été synthétisé en suivant la procédure décrite par Fallais et al. (J. Polym Sci Part A. Polym. Chem. 2000, 38, 1618) à partir de chaînes de ω-hydroxyéthylpolystyrène (Polymer Source Inc.) (Mn = 3700 g/Mol ; indice de polydispersité, PI = 1,08).

### b) Synthèse de N-maltoheptaosyl-3-acétamido-1-propyne

Une suspension de maltoheptaose (10,0 g, 8,67 mmol), dans la propargylamine (11,9 mL, 174 mmol) a été fortement agitée à température ambiante pendant 72 heures. La réaction a été suivie par chromatographie sur couches minces (éluant : n-butanol/éthanol/eau : 1/3/1, v/v/v). Après disparition complète du produit de départ, le milieu réactionnel a été dilué dans du méthanol (100 mL) puis précipité dans du dichlorométhane (300 mL). Le solide a été filtré et lavé par un mélange de méthanol et de dichlorométhane (méthanol/dichlorométhane : 1/3, v/v ; 300 mL).

Une solution d'anhydride acétique (Sigma Aldrich) dans le méthanol (anhydride acétique/méthanol : 1/20, v/v ; 1 L) a été ajoutée au solide et le mélange réactionnel a été agité toute la nuit à température ambiante. Après disparition complète du produit de départ suivi par chromatographie sur couches minces (éluant : acétonitrile/eau : 13/7, v/v), le solvant du milieu réactionnel a été évaporé, et les traces d'anhydride acétique ont été éliminées par co-évaporation dans un mélange toluène/méthanol : 1/1, v/v). Le solide résultant a été dissout dans le l'eau et lyophilisé pour donner un solide blanc de N-maltoheptaosyl-3-acéthamido-1-propyne (8,75 g, 78%).

### c) Synthèse du copolymère dibloc (polystyrène (bloc (A))-maltoheptaose (bloc (B)):

Une solution de pentaméthyldiéthylènetriamine (PMDETA) (2,24 mL, 1,07.10⁻⁴ mol, deux équivalents) a été dissoute dans du diméthylformamide (20 mL) puis ajoutée dans un ballon sous argon contenant le ω-azido-polystyrène (200 mg, 5,36.10⁻⁵ mol, un équivalent), le N-maltoheptaosyl-3-acétamido-1-propyne (198 mg, 1,61.10⁻⁴ mol, trois équivalents) et un catalyseur CuBr (15 mg, 1,07.10⁻⁴ mol, deux équivalents). Le milieu réactionnel a été agité à 40°C pendant 72 heures jusqu'à ce que le spectre infrarouge montre une disparition complète de la bande du groupement azido (à 2100 cm⁻¹). Le copolymère polystyrène-maltoheptaose a finalement été précipité deux fois dans le méthanol pour éliminer les excès de réactif, puis séché à 60°C sous vide.

### EXEMPLE 2 : Préparation d'un copolymère dibloc polystyrène-maltoheptaose lié par liaison hydrogène à la 4,4'-bipyridine.

Dans une solution de tétrahydrofurane contenant 0,1% en poids de copolymère dibloc polystyrène-maltoheptaose de l'exemple 1 a été ajouté un équivalent de 4',4-bipyridine (Sigma Aldrich) par groupement hydroxyle présent sur les blocs de maltoheptaose. Cette solution a ensuite été agitée énergiquement un jour à température ambiante afin de permettre la formation de liaisons hydrogènes entre les groupes hydroxyle et les molécules de bipyridine.

Des spectres infrarouge à transformées de Fourier (FTIR) ont été réalisés (figure 1) sur le copolymère dibloc polystyrène-maltoheptaose (courbe a) et sur la 4,4' bipyridine (courbe c) ainsi que sur le copolymère dibloc polystyrène-maltoheptaose lié par liaison hydrogène à la 4,4'-bipyridine (courbe c).

### EXEMPLE 3 : Réalisation d'un film organisé à organisation perpendiculaire de nanodomaines (M⊥)

Le film a été réalisé à partir du copolymère dibloc de l'exemple 2, comprenant la 4,4'-bipyridine. Une solution de ce copolymère (fraction volumique 40%) dans le THF a été déposée à la tournette (« spin coating ») (paramètres de dépôt: v=3000 tours/mn, a=1000 tours/mn/s et t=30 s) sur un substrat silicium. Le film fraîchement déposé a été porté à recuire un jour à 170°C sous vide afin de permettre la séparation de phases conduisant à la formation de nanodomaines constitués d'oligosaccharides liés par liaison hydrogène à la 4',4-bipyridine organisés dans un réseau cubique centré (figure 2). La phase d'une vue en coupe correspondant à une ligne continue sur l'image en microscopie à force atomique de la figure 2 est représentée en figure 3. Chaque pic correspond à un nanodomaine constitué de blocs d'oligosaccharides liés à la 4,4' bipyridine. La période du réseau obtenue est de 11 nm.

### EXEMPLE 4 : Réalisation d'un film à organisation parallèle de nanodomaines (M//).

Un film préparé à partir du copolymère de l'exemple 2 comprenant la 4,4'-bipyridine a été organisé en suivant le protocole de l'exemple 2 (recuit à 170°C pendant 24 h) par dépôt à la tournette (spin coating) sur un substrat silicium d'une solution du copolymère (fraction volumique 30%) dans un solvant THF/DMSO: 1/1, v/v. Le matériau obtenu a des nanodomaines organisés parallèlement au plan du substrat (figure 4).

### EXEMPLE 5 : Utilisation le matériau de l'exemple 3 pour la fabrication d'OLED.

Pour démontrer, deux films ont été préparés à partir du copolymère de l'exemple 2 comprenant la 4,4'-bipyridine avec recuit à 170°C pendant 15 minutes ou 45 heures afin d'aboutir à l'organisation des nanodomaines de maltoheptaose lié par liaison hydrogène à la 4',4-bipyridine dans un système cubique centré (figure 2). Les spectres en photoluminescence (excitation à 365 nm) de ces films sont représentés dans la figure 5 et démontrent la faisabilité de l'application des matériaux pour la fabrication d'OLED. Ces spectres montrent également que l'intensité de photoluminescence est meilleure pour le film exposé à un recuit plus long qui a permis une meilleure organisation des nanodomaines.

### EXEMPLE 6 : Retrait sélectif de nanodomaines polysaccharidiques du film pour obtenir le matériau (M_{TROU}) utilisable dans des applications en micro- ou nano-électronique.

Le traitement du matériau de l'exemple 3 a été traité par une solution d'acide trifluoracétique pour ôter sélectivement les nanodomaines maltoheptaose et former des cavités séparées les unes des autres par le polystyrène restant, qui pourra être utilisé pour préparer une mémoire flash (figure 6), un transistor vertical (figure 7), une mémoire à accès non séquentiel (figure 8) ou pour réaliser des nanobiocapteurs. De manière alternative, le traitement peut être effectué par de l'acide chlorhydrique à la place de l'acide trifluoracétique.

## Revendications

1. Matériau (M) comprenant un substrat dont l'une des surfaces est recouverte d'une couche d'un réseau organisé à base d'un copolymère à blocs comprenant :
- un bloc (A) constitué d'un polymère hydrophobe, et
- un bloc (B) constitué d'un polysaccharide.

2. Matériau (M) selon la revendication 1, dans lequel le copolymère à blocs a une masse moléculaire moyenne en poids inférieure ou égale à 40 000 g/mol.

3. Matériau (M) selon la revendication 1 ou 2, dans lequel le polysaccharide du bloc (B) est du maltoheptaose.

4. Matériau (M) selon l'une quelconque des revendications 1 à 3, dans lequel le polymère du bloc (A) est constitué de polystyrène, de poly(alkyl (méth)acrylate ou de poly (3-hexylthiophène).

5. Matériau (M) selon l'une quelconque des revendications 1 à 4, dans lequel le bloc (B) est lié par liaison hydrogène à au moins une molécule comprenant une fonction amine, amide, hydroxyle et/ou une fonction acide carboxylique, notamment la 4',4-bipyridine, la 2',2-bipyridine, la 2-(2,4-difluoro phenyl)pyridine ou l'acide 9-anthracène carboxylique.

6. Matériau (M) selon la revendication 5, dans lequel ladite molécule est la 4',4-bipyridine, la 2',2-bipyridine, la 2-(2,4-difluoro phenyl)pyridine ou l'acide 9-anthracène carboxylique.

7. Matériau (M) selon l'une quelconque des revendications 1 à 6, dans lequel le substrat comprend du silicium.

8. Matériau (M) selon l'une quelconque des revendications 1 à 6, dans lequel le substrat est un polymère, du verre, un métal ou un oxyde métallique.

9. Matériau selon l'une quelconque des revendications 1 à 8, comprenant un substrat en silicium dont l'une des surfaces est recouverte d'une couche d'un réseau organisé à base d'un copolymère à blocs comprenant :
- un bloc (A) constitué d'un polymère polystyrène de degré de polymérisation de 18, et
- un bloc (B) constitué d'un maltoheptaose de degré de polymérisation de 7, ledit maltoheptaose étant lié par liaison hydrogène à la 4',4-bipyridine.

10. Procédé de préparation d'un matériau (M) selon l'une quelconque des revendications 1 à 9, comprenant les étapes consistant en :
α) le dépôt d'une solution comprenant ledit copolymère à blocs sur un substrat pour obtenir un matériau (m),
β) le chauffage du matériau (m) obtenu à la fin de l'étape α) à une température de 140 à 220 °C

11. Utilisation d'un matériau selon l'une quelconque des revendications 1 à 9 à titre de précurseur d'un masque lithographique en électronique.

12. Matériau (M_{TROU}) susceptible d'être obtenu par un procédé comprenant l'étape a) consistant à traiter la couche de copolymère du matériau (M) selon l'une quelconque des revendications 1 à 9 de manière à éliminer sélectivement l'un des blocs (A) ou (B) et à former des cavités séparées les unes des autres par le reste du copolymère.

13. Utilisation d'un matériau (M_{TROU}) selon la revendication 12 comme masque lithographique en électronique, notamment pour la préparation d'une mémoire flash, d'un transistor vertical ou d'une mémoire à accès non séquentiel.

14. Utilisation d'un matériau (M_{TROU}) selon la revendication 12 pour la fabrication de nanobiocapteurs et de nanobiopuces.

15. Diode électroluminescente organique ou cellule photovoltaïque organique comprenant un matériau (M) selon la revendication 5 ou 6 dans lequel le bloc (B) est lié par liaison hydrogène à une molécule comprenant une fonction amine, amide, hydroxyle et/ou une fonction acide carboxylique, ladite molécule étant photoluminescente.

## Patentansprüche

1. Werkstoff (M), ein Substrat umfassend, von dem eine der Oberflächen mit einer Schicht eines auf der Basis eines Blockcopolymers organisierten Gitters bedeckt ist, umfassend:
- einen Block (A), der aus einem hydrophoben Polymer gebildet ist, und
- einen Block (B), der aus einem Polysacharid gebildet ist.

2. Werkstoff (M) nach Anspruch 1, bei dem das Blockcopolymer eine gewichtsmittlere Molmasse kleiner oder gleich 40.000 g/mol aufweist.

3. Werkstoff (M) nach Anspruch 1 oder 2, bei dem das Polysaccharid des Blocks (B) eine Maltoheptaose ist.

4. Werkstoff (M) nach einem beliebigen der Ansprüche 1 bis 3, bei dem das Blockpolymer (A) aus einem Polysteren, Polyalkyl(meth)acrylat oder Poly(3-hexylthiophen) gebildet wird.

5. Werkstoff (M) nach einem beliebigen der Ansprüche 1 bis 4, bei dem der Block (B) durch Wasserstoffbindung an mindestens ein Molekül gebunden ist, das eine Amin-, Amid-, Hydroxylfunktion und/oder eine Carboxylsäurefunktion, insbesondere 4',4-Bipyridin, 2',2-Bipyridin, 2-(2, 4-Difluorphenyl)pyridin oder Anthracen-9-carbonsäure ist.

6. Werkstoff (M) nach Anspruch 5, bei dem das Molekül 4',4-Bipyridin, 2',2-Bipyridin, 2-(2, 4-Difluorphenyl)pyridin oder Anthracen-9-carbonsäure ist.

7. Werkstoff (M) nach einem beliebigen der Ansprüche 1 bis 6, bei dem das Substrat Silizium umfasst.

8. Werkstoff (M) nach einem beliebigen der Ansprüche 1 bis 6, bei dem das Substrat ein Polymer, Glas, Metall oder ein Metalloxid ist.

9. Werkstoff (M) nach einem beliebigen der Ansprüche 1 bis 8, ein Siliziumsubstrat umfassend, dessen eine der Oberflächen mit einer Schicht eines auf der Basis eines Blockcopolymers organisierten Gitters bedeckt ist, umfassend:
- einen Block (A), der aus einem Polysterenpolymer mit einem Polymerisationsgrad von 18 gebildet ist, und
- einen Block (B), der aus einer Maltoheptaose mit einem Polymerisationsgrad von 7 gebildet ist, wobei die Maltoheptaose durch eine Wasserstoffbindung an 4', 4-Bipyridin gebunden ist.

10. Verfahren zum Herstellen eines Werkstoffs (M) nach einem beliebigen der Ansprüche 1 bis 9, die Schritte umfassend, die darin bestehen:
α) Aufbringen einer Lösung, die das Blockpolymer umfasst, auf ein Substrat, um einen Werkstoff (m) zu erhalten,
β) Aufheizen des Werkstoffs (m), der am Ende des Schritts α) erhalten wird, auf eine Temperatur von 140 bis 220°C.

11. Verwendung eines Werkstoffs nach einem beliebigen der Ansprüche 1 bis 9 als Vorprodukt einer Lithografiemaske in der Elektronik.

12. Werkstoff (M_{TROU}),der geeignet ist, durch ein Verfahren erhalten zu werden, das den Schritt a) umfasst, der darin besteht, die Copolymerschicht des Werkstoffs (M) nach einem beliebigen der Ansprüche 1 bis 9 so zu behandeln, dass selektiv einer der Blöcke (A) oder (B) eliminiert wird und Hohlräume gebildet werden, die durch den Rest des Copolymers voneinander getrennt sind.

13. Verwendung eines Werkstoffs (M_{TROU}) nach Anspruch 12 als Lithografiemaske in der Elektronik, insbesondere für die Herstellung eines Flash-Speichers, eines vertikalen Transistors oder eines Speichers mit nichtsequentiellem Zugriff.

14. Verwendung eines Werkstoffs (M_{TROU}) nach Anspruch 12 für die Herstellung von Nanobiosensoren und Nanobiochips.

15. Organische Leuchtdiode oder organische Photovoltaikzelle, ein Werkstoff (M) nach den Ansprüchen 5 oder 6 umfassend, bei dem der Block (B) durch eine Wasserstoffbindung an ein Molekül gebunden ist, das eine Amin-, Amid-, Hydroxylfunktion und/oder eine Carbonsäurefunktion umfasst, wobei das Molekül fotolumineszierend ist.

## Claims

1. A material (M) comprising a substrate, one of the surfaces of which is covered with a layer of an organized network based on a block copolymer comprising:
- a block (A) consisting of a hydrophobic polymer, and
- a block (B) consisting of a polysaccharide.

2. The material (M) according to claim 1, wherein the block copolymer has a weight average molecular weight of less than or equal to 40,000 g/mol.

3. The material (M) according to claim 1 or 2, wherein the polysaccharide of block (B) is maltoheptaose.

4. The material (M) according to any of claims 1 to 3, wherein the polymer of block (A) consists of polystyrene, poly(alkyl (meth)acrylate) or poly(3-hexylthiophene).

5. The material (M) according to any of claims 1 to 4, wherein the block (B) is bound through a hydrogen bond to at least one molecule comprising an amine, amide, hydroxyl function and/or a carboxylic acid function, notably 4,4'-bipyridine, 2',2-bipyridine, 2-(2,4-difluorophenyl)pyridine or 9-anthracene carboxylic acid.

6. The material (M) according to claim 5, wherein said molecule is 4,4'-bipyridine, 2',2-bipyridine, 2-(2,4-difluorophenyl)pyridine or 9-anthracene-carboxylic acid.

7. The material (M) according to any of claims 1 to 6, wherein the substrate comprises silicon.

8. The material (M) according to any of claims 1 to 6, wherein the substrate is a polymer, glass, metal or a metal oxide.

9. The material according to any of claims 1 to 8, comprising a silicon substrate, one of the surfaces of which is covered with a layer of an organized network based on a block copolymer comprising:
- a block (A) consisting of a polystyrene polymer with a degree of polymerization of 18, and
- a block (B) consisting of a maltoheptaose with a degree of polymerization of 7, said maltoheptaose being bound through a hydrogen bond to 4',4-bipyridine.

10. A method for preparing a material (M) according to any of claims 1 to 9, comprising the steps consisting in:
α) depositing a solution comprising said block copolymer on a substrate in order to obtain a material (m),
β) heating the material (m) obtained at the end of step α) to a temperature from 140 to 220°C.

11. The use of a material according to any of claims 1 to 9, as a precursor for a lithographic mask in electronics.

12. A material (M_{HOLE}) obtainable by a method comprising step a) consisting of treating the copolymer layer of the material (M) according to any of claims 1 to 9, so as to selectively remove one of the blocks either (A) or (B) and to form cavities separated from each other by the remainder of the copolymer.

13. The use of a material (M_{HOLE}) according to claim 12 as a lithographic mask in electronics, notably for preparing a flash memory, a vertical transistor or a non-sequential access memory.

14. The use of a material (M_{HOLE}) according to claim 12 for preparing nanobiosensors and nanobiochips.

15. An organic light-emitting diode or organic photovoltaic cell comprising a material (M) according to claim 5 or 6, wherein the block (B) is bound through a hydrogen bond to a molecule comprising an amine, amid, hydroxyl function and/or a carboxylic acid function, said molecule being photoluminescent.
